# EUROPEAN PATENT APPLICATION

(11) **EP 4 647 789 A1**
(43) Date of publication of application: **12.11.2025**
(21) Application number: 24753497.7
(22) Date of filing: 19.01.2024
(51) Int. Cl.: G01R 31/374, G01R 31/396, G01R 31/385, G01R 31/389, G01R 19/10, G01R 19/165, G01R 31/371

(54) **BATTERY MANAGEMENT DEVICE AND SERVER, AND BATTERY SYSTEM COMPRISING SAME**

(30) Priority: 09.02.2023 KR 20230017447
(71) Applicant: LG Energy Solution, Ltd., Seoul 07335 (KR)
(72) Inventor: JUNG, Joong Heum, Daejeon 34122 (KR)
(74) Representative: Plasseraud IP
(86) International application number: PCT/KR2024/000998
(87) International publication number: WO 2024/167165

(57) **Abstract**

A battery management apparatus according to an embodiment disclosed herein includes a data management unit configured to manage resistance data related to a bus bar of each of a plurality of battery banks included in a battery module and a controller configured to measure a voltage of each of the plurality of battery banks and calculate a corrected voltage of each of the plurality of battery banks by reflecting the resistance data related to the bus bar of each of the plurality of battery banks to a voltage of each of the plurality of battery banks.

## Description

### [TECHNICAL FIELD]

### CROSS-REFERENCE TO RELATED APPLICATION

This application claims priority to and the benefit of Korean Patent Application No. 10-2023-0017447 filed in the Korean Intellectual Property Office on February 9, 2023, the entire content of which is incorporated herein by reference.

### TECHNICAL FIELD

Embodiments disclosed herein relate to a battery management apparatus, a server, and a battery management system including them.

### [BACKGROUND ART]

An electric vehicle is supplied with electricity from outside to charge a battery, and then a motor is driven by a voltage charged in the battery to obtain power. The battery of the electric vehicle may have heat generated therein by chemical reaction occurring in a process of charging and discharging electricity, and the heat may impair performance and lifetime of the battery. Thus, a battery management apparatus (or a battery management system (BMS)) that monitors temperature, voltage, and current of the battery diagnoses and controls the state of the battery.

In a battery module electrically connecting a plurality of batteries by using a bus bar, a bus bar resistance is generated due to a current path formed in the bus bar and a voltage deviation between batteries occurs due to the bus bar resistance. Thus, the battery management apparatus has a problem of making it difficult to accurately diagnose a battery cell due to an error in battery voltage measurement.

### [DISCLOSURE]

### [TECHNICAL PROBLEM]

Embodiments disclosed herein aim to provide a battery management apparatus, a server, and a battery system including the battery management apparatus and the server in which a voltage of a battery may be accurately measured by reflecting a resistance due to a bus bar structure of a battery module and the battery may be diagnosed early.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein includes a data management unit configured to manage resistance data related to a bus bar of each of a plurality of battery banks included in a battery module and a controller configured to measure a voltage of each of the plurality of battery banks and calculate a corrected voltage of each of the plurality of battery banks by reflecting the resistance data related to the bus bar of each of the plurality of battery banks to a voltage of each of the plurality of battery banks.

According to an embodiment, the data management unit may be further configured to manage the resistance data related to the bus bar of each of the plurality of battery banks corresponding to identification information of the battery module.

According to an embodiment, the data management unit may be further configured to obtain the resistance data related to the bus bar of each of the plurality of battery banks corresponding to a serial number of the battery module from the server configured to manage resistance data related to a bus bar of a battery bank.

According to an embodiment, the controller may be further configured to calculate a corrected voltage of each of the plurality of battery banks by reflecting a product of a current value of the battery pack and the bus bar resistance of each of the plurality of battery banks to a voltage of each of the plurality of battery banks, when a current of the battery pack is generated.

According to an embodiment, the controller may be further configured to set a reference voltage based on the corrected voltage of each of the plurality of battery banks and diagnose a voltage deviation among the plurality of battery banks based on the reference voltage.

A server according to an embodiment disclosed herein includes a controller configured to match and manage identification information of each of a plurality of battery banks included in a battery module and resistance data related to the bus bar of each of the plurality of battery banks and a communication unit configured to transmit the resistance data related to the bus bar of each of the plurality of battery banks to a battery management apparatus of a battery pack including the battery bank.

According to an embodiment, the communication unit may be further configured to receive direct current internal resistance (DCIR) data of the battery module from a battery manufacturing device or a programmable logic controller.

According to an embodiment, the controller may be further configured to generate the resistance data related to the bus bar of each of the plurality of battery banks based on the DCIR of each of the plurality of battery banks.

According to an embodiment, the communication unit may be further configured to transmit the resistance data related to a bus bar of a battery bank corresponding to a serial number of the battery module included in the battery pack to the battery management apparatus, in production of the battery pack.

A battery system according to an embodiment disclosed herein includes a server configured to match and manage identification information of each of a plurality of battery banks included in a battery module and resistance data related to the bus bar of each of the plurality of battery banks and a battery management apparatus configured to measure a voltage of each of the plurality of battery banks and calculate a corrected voltage of each of the plurality of battery banks by reflecting the resistance data related to the bus bar of each of the plurality of battery banks to a voltage of each of the plurality of battery banks.

According to an embodiment, the server may be further configured to generate the resistance data related to the bus bar of each of the plurality of battery banks based on a direct current internal resistance (DCIR) of each of the plurality of battery banks.

According to an embodiment, the server may be further configured to transmit the resistance data related to a bus bar of a battery bank corresponding to a serial number of the battery module included in the battery pack to the battery management apparatus, in production of the battery pack.

According to an embodiment, the battery management apparatus may be further configured to calculate a corrected voltage of each of the plurality of battery banks by reflecting a product of a current value of the battery pack and the bus bar resistance of each of the plurality of battery banks to a voltage of each of the plurality of battery banks, when a current of the battery pack is generated.

According to an embodiment, the battery management apparatus may be further configured to set a reference voltage based on the corrected voltage of each of the plurality of battery banks and diagnose a voltage deviation among the plurality of battery banks based on the reference voltage.

### [ADVANTAGEOUS EFFECTS]

With the battery management apparatus, the server, and the battery system including them according to an embodiment disclosed herein, the voltage of the battery may be accurately measured by reflecting the resistance due to the bus bar structure of the battery module, and the battery may be diagnosed early.

### [DESCRIPTION OF DRAWINGS]

FIG. 1 is a block diagram illustrating a configuration of a battery system, according to an embodiment disclosed herein.
FIG. 2 is a block diagram illustrating a configuration of a server according to an embodiment disclosed herein.
FIG. 3 is a graph showing an internal resistance value of a battery bank according to an embodiment disclosed herein.
FIG. 4 is a diagram showing a battery pack according to an embodiment disclosed herein.
FIG. 5 is a block diagram illustrating a configuration of a battery management apparatus, according to an embodiment disclosed herein.
FIG. 6 is a flowchart showing an operating method of a battery management apparatus, according to an embodiment disclosed herein.
FIG. 7 is a block diagram showing a hardware configuration of a computing system for performing an operating method of a battery management apparatus, according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

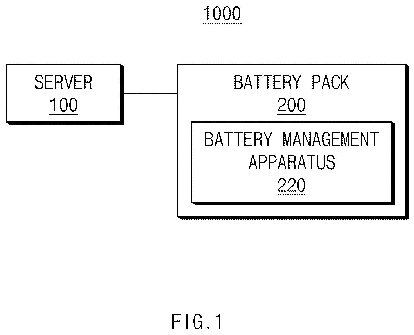

FIG. 1 is a block diagram illustrating a configuration of a battery system, according to an embodiment disclosed herein.

Referring to FIG. 1, a battery system may include a server 100 and a battery pack 200 that may include a battery management apparatus 220.

The server 100 may generate battery resistance-related data for voltage measurement of a plurality of batteries. The server 100 may generate the battery resistance-related data optimized for the plurality of batteries and transmit the generated battery resistance-related data to the battery management apparatus 220 of the battery pack 200.

The battery management apparatus 220 of the battery pack 200 may receive the battery resistance-related data optimized for the plurality of batteries from the server 100 and measure and correct the voltages of the batteries.

The battery management apparatus 220 may accurately measure the voltages of the batteries mounted on the vehicle by using the battery resistance-related data received by communicating with the server 100. Herein, the vehicle may include an electric vehicle driven by rotating a motor with electricity accumulated in the battery.

The battery management apparatus 220 may analyze and manage battery data by using the server 100 having a rich computing resource. The battery management apparatus 220 may precisely analyze the battery data through the server 100 to obtain battery data optimized for operating the battery.

Hereinbelow, each of the battery management apparatus 220 and the server 100 will be described in detail.

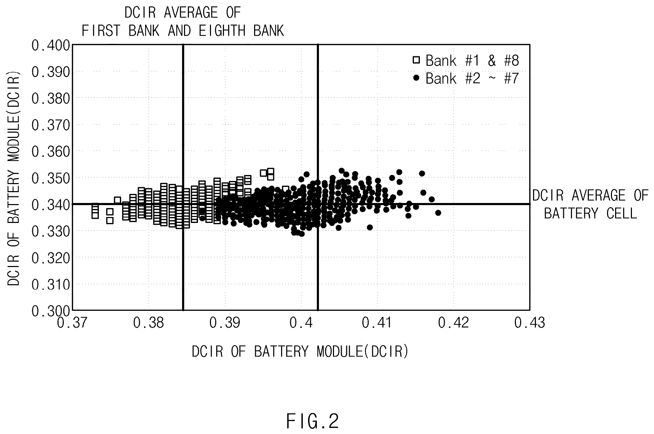

FIG. 2 is a block diagram illustrating a configuration of a server according to an embodiment disclosed herein.

Referring to FIG. 2, the server 100 may include a communication unit 110 and a controller 120.

The communication unit 110 may gather data of battery manufacturing devices (not shown) operating in a battery manufacturing process. The communication unit 110 may gather operation data of the battery manufacturing device. In addition, the communication unit 110 may gather operation data of a programmable logic controller (PLC, not shown) for controlling the battery manufacturing device. Herein, the operation data of the PLC may include an operation record of the battery manufacturing device.

According to various embodiments, a battery may include a battery cell that is a basic unit of a battery capable of using electric energy by charge and discharge. The battery cell may be a lithium ion (Li-ion) battery, an Li-ion polymer battery, a nickelcadmium (Ni-Cd) battery, a nickel hydrogen (Ni-MH) battery, etc., and is not limited thereto. The battery cell may supply power to a target device (not shown). To this end, the battery cell may be electrically connected to the target device. Herein, the target device may include an electrical, electronic, or mechanical device that operates by receiving power from a battery pack including a plurality of battery cells. Herein, the target device may be, but not limited to, large products that require high output, such as electric vehicles or hybrid vehicles, and power storage devices that store surplus power or renewable energy or power storage devices for backup as well as small products such as digital cameras, P-DVDs, MP3P, mobile phones, PDAs, portable game devices, power tools, E-bikes, etc.

The battery cell may be manufactured through a series of manufacturing processes including an electrode manufacturing process, an assembly process, a chemical conversion process, etc., and manufactured battery cells may be connected in series or in parallel to each other and embedded in a case structure to implement the battery module. A battery pack assembly process may include performing a bolting job after mounting a plurality of battery modules and a battery management apparatus on a battery pack main body. In the battery pack assembly process, after assembly of the battery module is finished, each battery module is connected and a battery pack cover is assembled.

Depending on an embodiment, the battery module may include a plurality of battery banks. Herein, the battery bank may be defined as one serial line including a plurality of battery cells in the battery module. The plurality of battery banks may be serially connected to each other in the battery module. In addition, the plurality of battery cells included in each of the plurality of battery banks may be connected in parallel to each other. The battery module may include a solid frame to protect the plurality of battery banks against an external shock such as heat, vibration, etc. More specifically, the plurality of battery banks included in the battery module may be serially connected to each other through a bus bar.

The communication unit 110 may obtain and manage internal resistance (direct current internal resistance (DCIR)) data of the battery module, measured in an end-of-line (EOL) of the battery module from the battery manufacturing device or the PLC in an assembly process of the battery module.

More specifically, the communication unit 110 may obtain and manage resistance data related to the bus bar of the plurality of battery banks included in the battery module. Herein, the bus bar may include an inner bus bar. The bus bar may form a current path in a DCIR measurement test of the battery bank. Thus, in the DCIR measurement test of the battery bank, a bus bar resistance may occur due to the current path of the bus bar. The bus bar resistance may cause a voltage drop phenomenon of the battery bank, resulting in a voltage deviation between the plurality of battery banks and a difference in internal resistance value.

The battery manufacturing device or the PLC of the assembly process of the battery module may measure a voltage of the plurality of battery banks included in the battery module in the EOL of the battery module. The controller 120 may determine at least one battery bank where a voltage deviation occurs among the plurality of battery banks, based on voltage data of the plurality of battery banks, obtained from the battery manufacturing device or the PLC in the EOL of the assembly process of the battery module. The controller 120 may calculate an average of voltage reduction amounts of battery banks where a voltage deviation occurs when compared to a voltage of a normal battery bank among the plurality of battery banks.

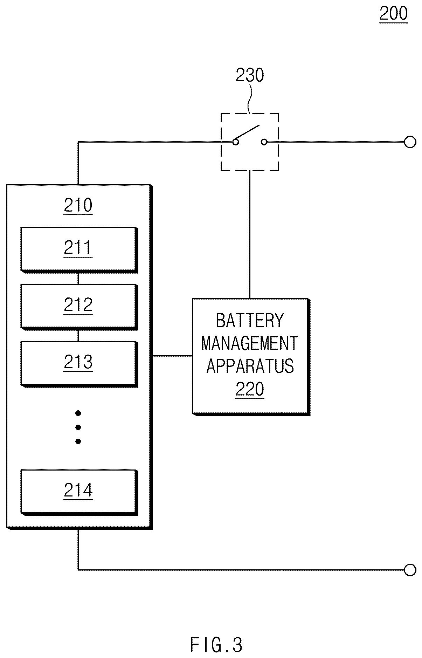

FIG. 3 is a graph showing a DCIR of a battery bank according to an embodiment disclosed herein.

Referring to FIG. 3, for example, a plurality of battery modules may include 8 battery banks. The server 100 may determine second battery bank to seventh battery bank where a voltage drop occurs, based on voltages of the 8 battery banks.

The controller 120 may calculate an internal resistance of each battery bank based on the voltages of the 8 battery banks and a current value of the DCIR test. For example, the controller 120 may calculate an average internal resistance of the first battery bank to the eighth battery bank as 0.385 Ω. In addition, the controller 120 may calculate an average internal resistance of the second battery bank to the seventh battery bank as 0.402 Ω.

The controller 120 may calculate an average of voltage reduction amounts of the second battery bank to the seventh battery bank where a voltage drop occurs when compared to the first battery bank and the eighth battery bank that are normal battery banks among the 8 battery banks. The controller 120 may calculate a value obtained by dividing the average of the voltage reduction amounts of the second battery bank to the seventh battery bank by the current value of the DCIR test of the plurality of battery banks.

The controller 120 may calculate a bus bar resistance of the second battery bank to the seventh battery bank by dividing the average of the voltage reduction amounts of the second battery bank to the seventh battery bank by the current value of the DCIR test of the plurality of battery banks.

The controller 120 may generate and manage bus bar resistance data of some battery banks where a voltage drop occurs. The controller 120 may match and manage identification information of each of the plurality of battery banks included in the battery module and the bus bar resistance data of each of the plurality of battery banks. Herein, the identification information of each of the plurality of battery banks included in the battery module may include a serial number of a corresponding battery module. That is, the controller 120 may match and manage the serial number of the battery module and the bus bar resistance data of each of the plurality of battery banks included in the battery module.

More specifically, the controller 120 may determine a serial number of a battery module included in the battery pack 200 and then transmit bus bar resistance data of a plurality of battery banks corresponding to the serial number of the battery module to the battery management apparatus 220, in an assembly process of the battery pack 200.

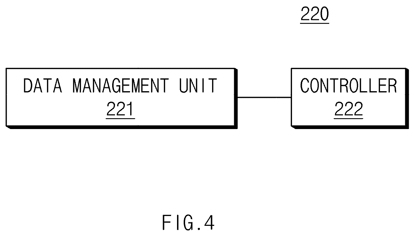

Hereinbelow, the battery pack and the battery management apparatus will be described in detail with reference to FIG. 4.

FIG. 4 is a diagram showing a battery pack according to an embodiment disclosed herein.

Referring to FIG. 4, a battery pack 200 according to an embodiment disclosed herein may include a battery module 210, a battery management apparatus 220, and a relay 230.

The battery module 210 may supply power to a target device (not shown). To this end, the battery module 210 may be electrically connected to the target device. Herein, the target device may include an electrical, electronic, or mechanical device that operates by receiving power from the battery pack 200 including the battery module 210, and the target device may be, for example, an electric vehicle (EV) or an energy storage system (ESS), but is not limited thereto.

The battery module 210 may include a plurality of battery banks 211, 212, 213, and 214. Herein, the battery bank may be defined as one serial line including a plurality of battery cells in the battery module 210. Although the plurality of battery banks 211, 212, 213, and 214 are illustrated as four in FIG. 3, the present disclosure is not limited thereto, and the battery module 210 may include n battery banks (n is a natural number equal to or greater than 2). Depending on an embodiment, the plurality of battery banks 211, 212, 213, and 214 may be electrically connected to each other to constitute a cell module assembly (CMA). Depending on an embodiment, the plurality of battery banks 211, 212, 213, and 214 may be connected in series to each other in the battery module 210.

The plurality of battery banks 211, 212, 213, and 214 may include a plurality of battery cells. According to an embodiment, the plurality of battery cells included in each of the plurality of battery banks 211, 212, 213, and 214 may be connected in parallel to each other. According to an embodiment, the plurality of battery cells included in each of the plurality of battery banks 211, 212, 213, and 214 may be connected in parallel to each other. The number of battery cells connected in parallel in the plurality of battery banks, 211, 212, 213, and 214 may be the same.

The battery management apparatus (or a BMS) 220 may manage and/or control a state and/or an operation of the battery module 210. For example, the battery management apparatus 220 may manage and/or control the states and/or operations of the plurality of battery banks 211, 212, 213, and 214 included in the battery module 210. The battery management apparatus 220 may manage charge and/or discharge of the battery module 210 and the plurality of battery banks 211, 212, 213, and 214 included in the battery module 210.

The battery management apparatus 220 may control an operation of the relay 230. For example, the battery management apparatus 220 may short-circuit the relay 230 to supply power to the target device. The battery management apparatus 220 may short-circuit the relay 230 when a charging device is connected to the battery pack 200.

In addition, the battery management apparatus 220 may monitor a voltage, a current, a temperature, an internal resistance, etc., of the battery module 210 and/or each of the plurality of battery banks 211, 212, 213, and 214 included in the battery module 210. A sensor or various measurement modules for monitoring performed by the battery management apparatus 220, which are not shown, may be additionally installed in the battery module 210, a charging/discharging path, any position of the battery module 210, etc. The battery management apparatus 220 may calculate a parameter indicating a state of the battery module 210, e.g., a state of charge (SOC) or a state of health (SOH), based on a measurement value such as monitored voltage, current, temperature, internal resistance, etc.

The battery management apparatus 220 may include a battery bank voltage correction logic using the bus bar resistance data of the plurality of battery banks 211, 212, 213, and 214 received from the server 100. The battery management apparatus 220 may correct a voltage of each battery bank by using the battery bank voltage correction logic.

The battery management apparatus 220 may obtain the bus bar resistance data from the server 100 in the battery pack assembly process. The battery management apparatus 220 may obtain the bus bar resistance data measured in the EOL of the battery module from the server 100. More specifically, the battery management apparatus 220 may obtain the bus bar resistance data of each of the plurality of battery banks 211, 212, 213, and 214 corresponding to the identification information of the battery module from the server 100. The battery management apparatus 220 may generate the battery bank voltage correction logic capable of reflecting a voltage drop due to a bus bar resistance of each of the plurality of battery banks 211, 212, 213, and 214, by using the bus bar resistance data of each of the plurality of battery banks 211, 212, 213, and 214.

For example, the battery management apparatus 220 may calculate a corrected voltage of each of the plurality of battery banks 211, 212, 213, and 214, by using the battery bank voltage correction logic reflecting the voltage drop due to the bus bar resistance of each of the plurality of battery banks 211, 212, 213, and 214 to a measured voltage of each of the plurality of battery banks 211, 212, 213, and 214, in driving of a vehicle having the battery pack 200 mounted thereon.

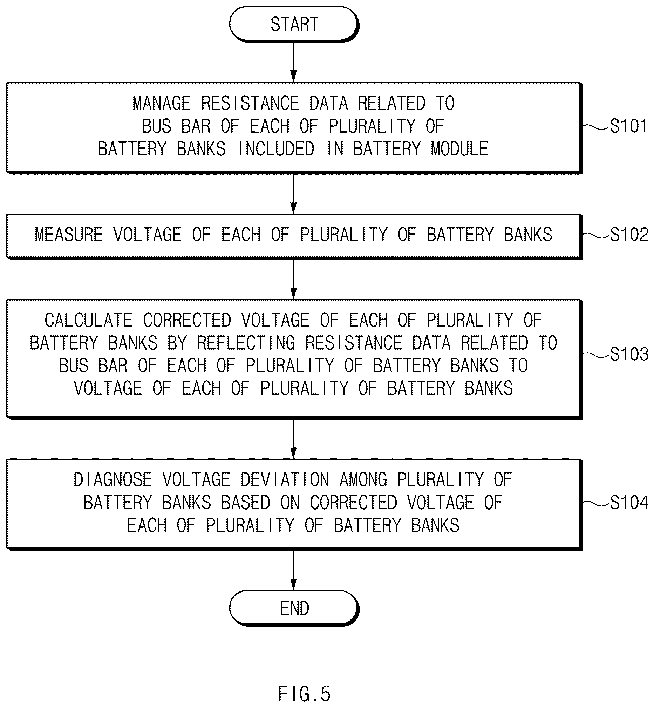

FIG. 5 is a block diagram illustrating a configuration of a battery management apparatus, according to an embodiment disclosed herein.

Hereinbelow, a configuration of the battery management apparatus 220 will be described in detail with reference to FIG. 5.

Referring to FIG. 5, the battery management apparatus 220 may include a data management unit 221 and a controller 222.

The data management unit 221 may manage the resistance data related to a bus bar of each of the plurality of battery banks 211, 212, 213, and 214 included in the battery module 210. The data management unit 221 may receive the bus bar resistance data of each of the plurality of battery banks 211, 212, 213, and 214 corresponding to the identification information of the battery module from the server 100. More specifically, the data management unit 221 may receive the bus bar resistance data of each of the plurality of battery banks 211, 212, 213, and 214 corresponding to the serial number of the battery module 210 from the server 100.

The controller 222 may measure a voltage of each of the plurality of battery banks 211, 212, 213, and 214. The controller 222 may calculate the corrected voltage of each of the plurality of battery banks 211, 212, 213, and 214 by reflecting the bus bar resistance data of each of the plurality of battery banks 211, 212, 213, and 214 to a voltage of each of the plurality of battery banks 211, 212, 213, and 214.

For example, the controller 222 may generate the battery bank voltage correction logic capable of reflecting a voltage drop due to a bus bar resistance of the plurality of battery banks 211, 212, 213, and 214, by using the bus bar resistance data of the plurality of battery banks 211, 212, 213, and 214. More specifically, the controller 222 may generate the battery bank voltage correction logic capable of reflecting a product of a current value of the battery pack 200 and a bus bar resistance of each of the plurality of battery banks 211, 212, 213, and 214 to the measured voltage of each of the plurality of battery banks 211, 212, 213, and 214, when the current of the battery pack 200 is generated.

The controller 222 may calculate the corrected voltage of each of the plurality of battery banks 211, 212, 213, and 214 by subtracting the product of the current value of the battery pack 200 and the bus bar resistance of each of the plurality of battery banks 211, 212, 213, and 214 from the measured voltage of each of the plurality of battery banks 211, 212, 213, and 214, by using the battery bank voltage correction logic.

The controller 222 may set a reference voltage based on the corrected voltage of each of the plurality of battery banks 211, 212, 213, and 214. For example, the controller 222 may set a Cut-OFF voltage based on the corrected voltage of each of the plurality of battery banks 211, 212, 213, and 214. Herein, the reference voltage may be defined as a reference value for determining that a voltage deviation occurs with a voltage difference between battery banks being greater than or equal to a specific threshold value.

The controller 222 may diagnose a voltage deviation between the plurality of battery banks 211, 212, 213, and 214, based on the reference voltage. The controller 222 may generate a diagnostic trouble code (DTC) when the voltage deviation occurs among the plurality of battery banks 211, 212, 213, and 214.

Depending on an embodiment, the controller 222 may measure the voltage of each of the plurality of battery banks 211, 212, 213, and 214 and then calculate the corrected voltage of each of the plurality of battery banks 211, 212, 213, and 214, by using the battery bank voltage correction logic reflecting the bus bar resistance data of each of the plurality of battery banks 211, 212, 213, and 214, in driving of the vehicle or electronic device having the battery pack 200 mounted thereon.

As described above, with the battery management apparatus and the battery system including the same according to an embodiment disclosed herein, by using a bus bar resistance of a battery bank due to a bus bar structure of a battery module, a voltage of the battery bank may be accurately measured.

Moreover, the battery management apparatus and the battery system may calculate the corrected voltage reflecting the bus bar resistance of the battery bank to early diagnose a battery bank where a voltage deviation occurs, thereby securing safety and reliability of battery energy.

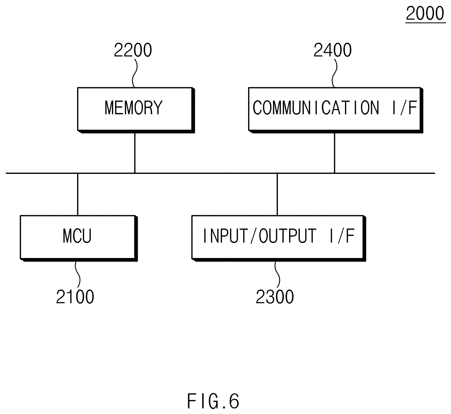

FIG. 6 is a flowchart showing an operating method of a battery management apparatus, according to an embodiment disclosed herein.

Hereinbelow, an operating method of the battery management apparatus 220 will be described with reference to FIGS. 1 and 5. The battery management apparatus 220 may be substantially the same as the battery management apparatus 220 described with reference to FIGS. 1 to 5, and thus will be briefly described to avoid redundant description.

Referring to FIG. 6, the operating method of the battery management apparatus 220 may include operation S101 of managing resistance data related to a bus bar of each of a plurality of battery banks included in a battery module, operation S102 of measuring a voltage of each of the plurality of battery banks, operation S103 of calculating a corrected voltage of each of the plurality of battery banks by reflecting the resistance data related to the bus bar of each of the plurality of battery banks to the voltage of each of the plurality of battery banks, and operation S104 of diagnosing a voltage deviation among the plurality of battery banks based on the corrected voltage of each of the plurality of battery banks.

In operation S101, the data management unit 221 may manage the resistance data related to the bus bar of each of the plurality of battery banks 211, 212, 213, and 214 included in the battery module 210.

In operation S101, the data management unit 221 may receive the bus bar resistance data of each of the plurality of battery banks 211, 212, 213, and 214 corresponding to the identification information of the battery module from the server 100. In operation S101, more specifically, the data management unit 221 may receive the bus bar resistance data of each of the plurality of battery banks 211, 212, 213, and 214 corresponding to the serial number of the battery module 210 from the server 100. Herein, the bus bar resistance data may be measured in the EOL of the assembly process of the battery module 210.

In operation S102, the controller 222 may measure the voltage of each of the plurality of battery banks 211, 212, 213, and 214.

In operation S103, the controller 222 may calculate the corrected voltage of each of the plurality of battery banks 211, 212, 213, and 214 by reflecting the bus bar resistance data of each of the plurality of battery banks 211, 212, 213, and 214 to a voltage of each of the plurality of battery banks 211, 212, 213, and 214. In operation S103, for example, the controller 222 may generate the battery bank voltage correction logic capable of reflecting a voltage drop due to a bus bar resistance of the plurality of battery banks 211, 212, 213, and 214, by using the bus bar resistance data of the plurality of battery banks 211, 212, 213, and 214.

In operation S103, more specifically, the controller 222 may generate the battery bank voltage correction logic capable of reflecting a product of a current value of the battery pack 200 and a bus bar resistance of each of the plurality of battery banks 211, 212, 213, and 214 to the measured voltage of each of the plurality of battery banks 211, 212, 213, and 214, when the current of the battery pack 200 is generated.

In operation S103, the controller 222 may calculate the corrected voltage of each of the plurality of battery banks 211, 212, 213, and 214 by subtracting the product of the current value of the battery pack 200 and the bus bar resistance of each of the plurality of battery banks 211, 212, 213, and 214 from the measured voltage of each of the plurality of battery banks 211, 212, 213, and 214, by using the battery bank voltage correction logic.

In operation S103, the controller 222 may set a reference voltage based on the corrected voltage of each of the plurality of battery banks 211, 212, 213, and 214. For example, the controller 222 may set a Cut-OFF voltage based on the corrected voltage of each of the plurality of battery banks 211, 212, 213, and 214. Herein, the reference voltage may be defined as a reference value for determining that a voltage deviation occurs with a voltage difference between battery banks being greater than or equal to a specific threshold value.

In operation S103, depending on an embodiment, the controller 222 may measure the voltage of each of the plurality of battery banks 211, 212, 213, and 214 and then calculate the corrected voltage of each of the plurality of battery banks 211, 212, 213, and 214, by using the battery bank voltage correction logic reflecting the bus bar resistance data of each of the plurality of battery banks 211, 212, 213, and 214, in driving of the vehicle or electronic device having the battery pack 200 mounted thereon.

In operation S104, the controller 222 may diagnose a voltage deviation between the plurality of battery banks 211, 212, 213, and 214, based on the reference voltage. In operation S104, the controller 222 may generate a DTC when the voltage deviation occurs among the plurality of battery banks 211, 212, 213, and 214.

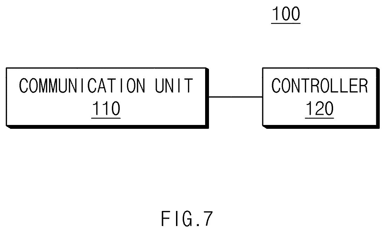

FIG. 7 is a block diagram showing a hardware configuration of a computing system for performing an operating method of a battery management apparatus, according to an embodiment disclosed herein.

Referring to FIG. 7, a computing system 2000 according to an embodiment disclosed herein may include an MCU 2100, a memory 2200, an input/output I/F 2300, and a communication I/F 2400.

The MCU 2100 may be a processor that executes various programs (e.g., a battery diagnosis program, etc.) stored in the memory 2200, processes various data through these programs, and perform the above-described functions of the battery management apparatus 220.

The memory 2200 may store various programs regarding operations of the battery management apparatus 220. Moreover, the memory 2200 may store operation data of the battery management apparatus 220.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

## Claims

1. A battery management apparatus comprising:
a data management unit configured to manage resistance data related to a bus bar of each of a plurality of battery banks included in a battery module; and
a controller configured to measure a voltage of each of the plurality of battery banks and calculate a corrected voltage of each of the plurality of battery banks by reflecting the resistance data related to the bus bar of each of the plurality of battery banks to a voltage of each of the plurality of battery banks.

2. The battery management apparatus of claim 1, wherein the data management unit is further configured to manage the resistance data related to the bus bar of each of the plurality of battery banks corresponding to identification information of the battery module.

3. The battery management apparatus of claim 2, wherein the data management unit is further configured to obtain the resistance data related to the bus bar of each of the plurality of battery banks corresponding to a serial number of the battery module from the server configured to manage resistance data related to a bus bar of a battery bank.

4. The battery management apparatus of claim 3, wherein the controller is further configured to calculate a corrected voltage of each of the plurality of battery banks by reflecting a product of a current value of the battery pack and the bus bar resistance of each of the plurality of battery banks to a voltage of each of the plurality of battery banks, when a current of the battery pack is generated.

5. The battery management apparatus of claim 4, wherein the controller is further configured to set a reference voltage based on the corrected voltage of each of the plurality of battery banks and diagnose a voltage deviation among the plurality of battery banks based on the reference voltage.

6. A server comprising:
a controller configured to match and manage identification information of each of a plurality of battery banks included in a battery module and resistance data related to each bus bar of each of the plurality of battery banks; and
a communication unit configured to transmit the resistance data related to the bus bar of each of the plurality of battery banks to a battery management apparatus of a battery pack comprising the battery bank.

7. The server of claim 6, wherein the communication unit is further configured to receive direct current internal resistance (DCIR) data of the battery module from a battery manufacturing device or a programmable logic controller.

8. The server of claim 6, wherein the controller is further configured to generate the resistance data related to the bus bar of each of the plurality of battery banks based on the DCIR of each of the plurality of battery banks.

9. The server of claim 8, wherein the communication unit is further configured to transmit the resistance data related to a bus bar of a battery bank corresponding to a serial number of the battery module included in the battery pack to the battery management apparatus, in production of the battery pack.

10. A battery system comprising:
a server configured to match and manage identification information of each of a plurality of battery banks included in a battery module and resistance data related to the bus bar of each of the plurality of battery banks; and
a battery management apparatus configured to measure a voltage of each of the plurality of battery banks and calculate a corrected voltage of each of the plurality of battery banks by reflecting the resistance data related to each bus bar of each of the plurality of battery banks to a voltage of each of the plurality of battery banks.

11. The battery system of claim 10, wherein the server is further configured to generate the resistance data related to the bus bar of each of the plurality of battery banks based on a direct current internal resistance (DCIR) of each of the plurality of battery banks.

12. The battery system of claim 11, wherein the server is further configured to transmit the resistance data related to a bus bar of a battery bank corresponding to a serial number of the battery module included in a battery pack to the battery management apparatus, in production of the battery pack.

13. The battery system of claim 12, wherein the battery management apparatus is further configured to calculate a corrected voltage of each of the plurality of battery banks by reflecting a product of a current value of the battery pack and the bus bar resistance of each of the plurality of battery banks to a voltage of each of the plurality of battery banks, when a current of the battery pack is generated.

14. The battery system of claim 13, wherein the battery management apparatus is further configured to set a reference voltage based on the corrected voltage of each of the plurality of battery banks and diagnose a voltage deviation among the plurality of battery banks based on the reference voltage.
